# EUROPÄISCHE PATENTSCHRIFT

(11) **EP 0 572 871 B1**
(45) Veröffentlichungstag und Bekanntmachung des Hinweises auf die Patenterteilung: **11.12.1996**
(21) Anmeldenummer: 93108224.2
(22) Anmeldetag: 20.05.1993
(51) Int. Cl.: H03K 17/96

(54) **Piezoelektrischer Taster**
Piezoelectric key switch
Commutateur piézo-électrique à touche

(30) Priorität: 26.05.1992 DE 4217351
(43) Veröffentlichungstag der Anmeldung: 08.12.1993
(73) Patentinhaber: Ing. Wolfgang Schäfer GmbH Elektrotechnik + Maschinenbau, D-72488 Sigmaringen (DE)
(72) Erfinder: Schäfer, Wolfgang, W-7480 Sigmaringen-Laiz (DE); Scholz, Marina, W-7481 Bingen (DE)
(74) Vertreter: Rüger, Rudolf, Dr.-Ing.

(56) Entgegenhaltungen:
- EP-A- 0 471 901
- EP-A- 0 525 374
- US-A- 4 618 797

## Beschreibung

Die Erfindung betrifft einen piezoelektrischen Taster, der insbesondere für Anwendungsfälle geeignet ist, in denen mit Vandalismus zu rechnen ist.

Aus dem Dokument EP-A-0 525 374, welches unter Artikel 54(3) fällt, ist ein weitgehend vandalensicherer piezoelektrischer Taster bekannt, der für die Anwendung im Aufzugsbereich geeignet ist. Der bekannte Taster weist ein Gehäuse auf, in dem eine zu der Frontseite des Gehäuses öffnende Kammer enthalten ist. Auf dem Boden der Kammer liegt eine kreisförmige, gummielastische Scheibe auf, die auf ihrer der Öffnung der Kammer zugekehrten Seite das piezokeramische Element trägt. Das piezokeramische Element besteht aus einer Keramikscheibe mit darauf befindlicher Metallscheibe, die randseitig über die Keramikscheibe übersteht. Das piezokeramische Element ist mit der Metallscheibe der Öffnung zugekehrt und über eine doppelseitige Klebefolie, die die Gestalt eines Ringes hat, mit der Betätigungsplatte verklebt, die sich innerhalb der Öffnung der Kammer befindet.

Die Betätigungsplatte ist flächenmäßig größer als das piezokeramische Element und kann sich mit ihrer der Kammer zugekehrten Innenseite auf eine in die Kammer vorspringende Schulter auflegen, falls mit übermäßiger Kraft auf die Betätigungsplatte eingewirkt wird. Dadurch ist das piezokeramische Element, das sandwichartig zwischen der Gummischeibe und der Betätigungsplatte liegt, gegen Beschädigung weitgehend geschützt.

Es hat sich allerdings gezeigt, daß, wenn beispielsweise ein Aufzugstableau mit derartigen piezokeramischen Tastern bestückt ist, Funktionsprobleme auftreten, wenn das Tableau feucht gereinigt wird. Es kann dabei Wasser in den Spalt zwischen der Öffnung und der Betätigungsplatte eindringen und das piezokeramische Element kurzschließen.

Außerdem muß bei der bekannten Anordnung die Stärke der Gummischeibe sehr genau auf den Abstand des Bodens der Kammer von der Schulter abgestimmt werden. Wenn die Scheibe zu dünn ist, ist beim Drücken auf die Betätigungsplatte keine ausreichende Verformung des piezokeramischen Elementes möglich. Wenn hingegen die Scheibe zu dick ist, ist möglicherweise der Schutz der piezokeramischen Scheibe ungenügend.

Aufgabe der Erfindung ist es, einen piezokeramischen Taster zu schaffen, der vandalensicher und weniger empfindlich gegenüber mechanischen Toleranzen der verwendeten Bauteile ist.

Zur Lösung dieser Aufgabe ist der erfindungsgemäße piezoelektrische Taster durch die Merkmale des Anspruches 1 gelöst.

Infolge der neuen Anordnung befindet sich das piezokeramische oder piezoelektrische Element an der Unterseite der Zwischenplatte, während die gegenüberliegende Seite des piezokeramischen Elementes vollständig frei ist und auch nicht gegen irgendwelche Teile anliegt. Die Stärke der Kupferplatte sowie der andwichartig darüberliegenden platten- oder scheibenförmigen Teile hat insoweit auf die Funktion des piezokeramischen Elementes keinen Einfluß. Es besteht auch praktisch kaum die Gefahr einer Beschädigung, wenn die Teile in der Summe stärker sind als konstruktionsmäßig vorgesehen, weil die Zwischenplatte erheblich zusätzlich zum Schutz des piezoelektrischen Elementes beiträgt. Gleichzeitig kann sie als Abdichtmittel dienen, um den Bereich der Kammer, in dem sich das piezokeramische Element befindet, gegenüber dem Außenbereich in Richtung Betätigungsplatte abzudichten. Die Dichtfläche ist dabei der entsprechende Rand der Zwischenplatte und die Auflagemittel, auf der die Zwischenplatte aufliegt. Die darüber befindliche Platte aus elastischem Material sorgt für eine gleichmäßige Druckverteilung und für eine im weitesten Sinne etwa kalottenförmige Verbiegung der zwischenplatte und der entsprechenden Durchbiegung des piezokeramischen Elementes.

Außerdem kann die elastische Platte zur Abdichtung herangezogen werden, wenn ihre Außenkontur dem Lichtraumprofil der Kammer im Bereich der Platte aus elastischem Material entspricht. Die Platte liegt dann mit ihrem Rand dichtend an der Wand der Kammer an und verhindert ein Eindringen von Feuchtigkeit.

Die zusätzlich vorgesehenen Anschlagmittel, die den Hub einer in die Kammer gerichteten Bewegung der Betätigungsplatte hart begrenzen, schützen zusätzlich das piezokeramische Element und den Stapel aus der Platte aus elastischem Material und die Zwischenplatte gegen Beschädigung, wenn mit Schlagwerkzeugen auf die Betätigungsplatte eingewirkt wird.

Günstige Einbauverhältnisse für das piezokeramische Element ergeben sich, wenn es aus einer Keramikscheibe mit einer damit stoffschlüssig verbundenen Metallscheibe besteht, die randseitig über die Keramikscheibe übersteht.

Die Abdichtung im Bereich der Zwischenplatte läßt sich noch verbessern, wenn die Auflageeinrichtung für die Zwischenplatte von einer durchgehenden, umlaufenden Schulter gebildet ist, auf der die Zwischenplatte aufliegt. Dabei kann die Zwischenplatte mit der Schulter verklebt werden, womit sich eine absolut flüssigkeitsdichte Verbindung ergibt, die jegliches Eindringen von Wasser in den Bereich des piezokeramischen Elementes verhindert.

Besonders einfach wird die Befestigung der Zwischenplatte und des piezokeramischen Elementes, wenn die Zwischenplatte auf ihrer dem piezokeramischen Element zugekehrten Seite durchgehend mit einer zweiseitig klebenden Folie versehen ist, weil dann einerseits auf diese Weise das piezokeramische Element an der Zwischenplatte gehaltert werden kann und die Zwischenplatte in dem Gehäuse abgedichtet festgelegt wird.

Hinsichtlich der Betätigungskraft ergeben sich günstige Verhältnisse, wenn die Zwischenplatte eine 0,4 mm starke Kupferplatte und die Platte aus elastischem Material eine etwa 1 mm starke Gummiplatte ist.

Die Betätigungskraft läßt sich noch weiter senken, wenn zwischen der Betätigungsplatte und der ihr zugekehrten Seite der Platte aus elastischem Material eine kreisscheibenförmige Zwischenlage angeordnet ist, deren Stärke etwa 0,17 mm beträgt. Diese Zwischenlage kann ebenfalls eine beidseitig klebende Folie sein, die gleichzeitig die Betätigungsplatte mit der elastischen Platte stoffschlüssig verbindet.

Die Anschlagmittel zum Begrenzen des Hub der Betätigungsplatte werden zwangsläufig erreicht, wenn die Betätigungsplatte aus zwei Abschnitten besteht, von denen der eine im Querschnitt an das Lichtraumprofil der Öffnung angepaßt ist, während der andere Abschnitt eine größere Fläche aufweist und sich auf den Rändern der Öffnung auflegen kann, um den Hub zu begrenzen.

Damit die Betätigungsplatte nicht aus dem Tastergehäuse herausgehebelt werden kann, sind zweckmäßigerweise Sicherungsmittel vorgesehen, die aus miteinander fluchtenden Bohrungen in dem Gehäuse und der Betätigungsplatte bestehen und in denen kleine Sicherungsbolzen stecken. Die Sicherungsbolzen haben entweder in den Bohrungen der Betätigungsplatte oder des Gehäuses Spiel, um die Beweglichkeit der Betätigungsplatte nicht zu behindern. Dabei genügt ein extrem kleines Spiel, denn der Hub bei dem neuen Taster ist kleiner als 0,05 mm.

In der Zeichnung ist ein Ausführungsbeispiel des Gegenstandes der Erfindung dargestellt. Es zeigen:
- Fig. 1: den erfindungsgemäßen Taster in einem Längsschnitt und
- Fig. 2: den Taster nach Fig. 1 in einer Explosionsdarstellung.

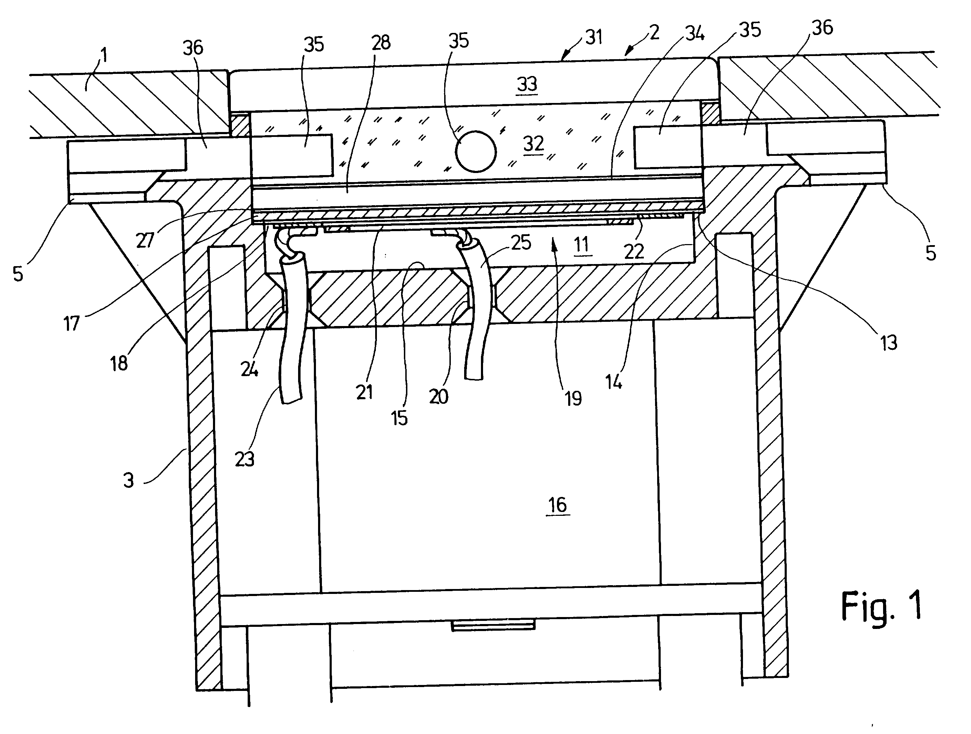

Fig. 1 zeigt einen in ein Bedientableau 1 eines Aufzugs eingebauten piezoelektrischen Taster 2. Der Taster 2 weist ein im wesentlichen quaderförmiges Gehäuse 3 auf, an dessen Frontseite 4 sich zwei in entgegengesetzte Richtung erstreckende Befestigungsflansche 5 befinden, mit denen der piezoelektrische Taster 2 an einer nicht weiter veranschaulichten Unterkonstruktion des Bedientableaus 1 befestigt ist. Die Frontseite 4 des Gehäuses 3 ist mit einer rechteckigen Öffnung 6 versehen, die von einem leistenartigen Rand 7 umgeben ist, der sich geringfügig über das Niveau der ansonsten ebenen Frontseite 4 erhebt. An die öffnung 6 schließt sich eine in das Innere des Gehäuses führende Kammer 8 an, die in zwei Abschnitte 9 und 11 unterteilt ist. Der Abschnitt 9 weist eine in sich geschlossene, unmittelbar in die öffnung 6 angrenzende Seitenwandanordnung 12 auf, die bei der öffnung 6 beginnt und bis zu einer Schulter 13 reicht. Der Abschnitt 9 der Kammer hat ausgehend von der Öffnung 6 bis hin zu der Schulter 13 durchgehend konstanten rechteckigen Querschnitt.

Die Schulter 13 definiert eine ebene Auflagefläche, die parallel und im Abstand zu einer von der Frontseite 4 definierten Ebene verläuft. An der Schulter 13 ändert sich der Querschnitt der Kammer 8 und geht von der Rechteckform in die Kreisform über. Der sich an die Schulter 13 in Richtung auf das Innere des Gehäuses 3 anschließende Abschnitt 11 hat die Gestalt eines Kreiszylinders und wird von einer Seitenwand 14 sowie einem im wesentlichen ebenen und wiederum zu der Frontseite 4 parallelen Boden 15 begrenzt.

Der Durchmesser des Abschnittes 11 ist so gewählt, daß an der Schulter 13 an jeder Stelle die Wand 14 gegenüber der Seitenwandanordnung 12 des Abschnittes 9 ein Stück weit radial nach innen vorspringt, so daß sich eine längs dem Umfang der Schulter 13 durchgehende ununterbrochene ebene Auflagefläche ergibt, die entsprechend der unterschiedlichen Querschnittsgestalt der beiden Abschnitte 9 und 11 unterschiedlich tief ist.

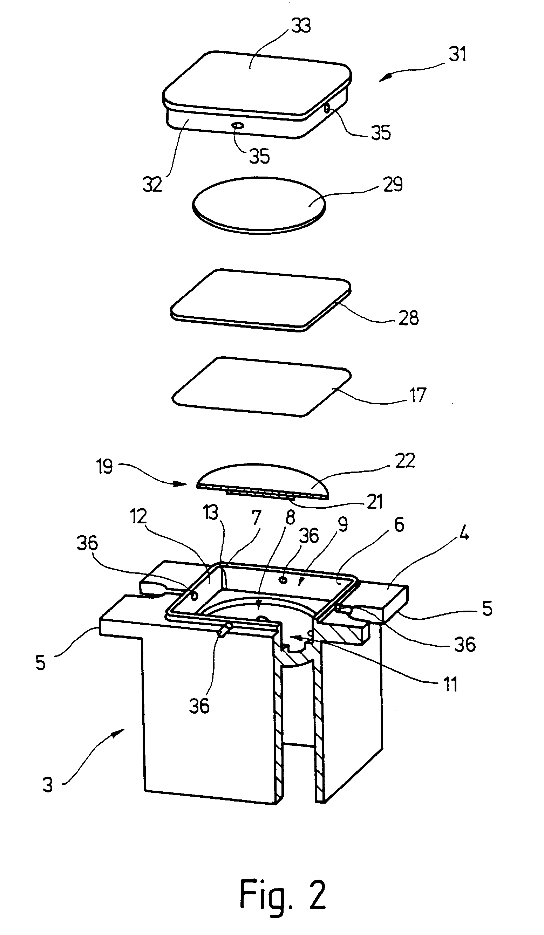

Der Vollständigkeit halber sei erwähnt, daß sich gegenüber der Rückseite des Bodens 15 innerhalb des Gehäuses 3 eine weitere Kammer 16 befindet, in der eine nicht weiter gezeigte elektronische Schaltung des piezoelektrischen Tasters 2 untergebracht ist. Die eigentlichen aktiven mechanischen Bauteile des piezoelektrischen Tasters 2 sind, wie die Fig. 1 und 2 erkennen lassen, sandwichartig übereinander angeordnet und stoffschlüssig miteinander verbunden. Auf der Schulter 13 liegt eine ebene, etwa 0,4 mm starke aus Kupfer bestehende zwischenplatte 17 auf, die an ihrer Unterseite, d.h. der dem Boden 15 zugekehrten Seite mit einer durchgehenden beidseitig klebenden Folie 18 versehen ist. Die Folie 18 erstreckt sich über die gesamte Fläche der Zwischenplatte 17. Ihre Außenkontur entspricht, bis auf ein geringfügiges seitliches Spiel, dem Querschnitt des Abschnittes 9 der Kammer 8. Mit Hilfe der beidseitig klebenden Folie 18 ist die aus Kupfer bestehende Zwischenplatte 17 mit der Schulter 13 durch Kleben stoffschlüssig verbunden.

Ebenfalls auf der Unterseite der Zwischenplatte 17 ist stoffschlüssig ein piezokeramisches Element 19 befestigt, das aus einer piezokeramischen kreisförmigen Scheibe 21 sowie einer kreisförmigen Metallscheibe 22 besteht, an der die piezokeramische Scheibe 21 elektrisch leitend befestigt ist. Die Scheibe 22 steht radial über die Keramikscheibe 21 über, so daß in dem überstehenden Randbereich eine elektrische Verbindungsleitung 23 bspw. durch Löten elektrisch leitend angeschlossen werden kann; die Verbindungsleitung 23 führt durch eine Bohrung 24 in dem Boden 15 zu der Kammer 16.

Die von der Scheibe 22 wegweisende Seite der Keramikscheibe 21 ist ebenfalls mit einer Metallisierung versehen, um eine zweite Verbindungsleitung 25 anzuschließen, die durch eine zu der Seitenwand 14 koaxiale Bohrung 26 in die Kammer 16 führt. Mit Hilfe der beiden Verbindungsleitungen 23 und 25 ist das piezokeramische Element 19 mit der nicht veranschaulichten elektronischen Schaltung verbunden, die in bekannter Weise ausgeführt ist.

Der Durchmesser der Metallscheibe 22 ist kleiner als der Durchmesser des zylindrischen Abschnitts 11 der Kammer 8.

Die Zwischenplate 17 trägt auf ihrer planen der Öffnung 6 zugekehrten Vorderseite eine weitere doppelseitig beschichtete Klebefolie 27, die dazu dient, die Zwischenplatte 17 mit einer aus Gummi oder Gummiersatzstoff bestehenden Platte 28 stoffschlüssig zu verbinden. Die Gummiplatte 28 hat eine Stärke von ca. 1 mm und eine Grundfläche entsprechend der Grundfläche der Zwischenplatte 17. Sie kann geringfügig größer sein, so daß sie ohne Spiel dichtend bis an die Seitenwand 12 der Kammer 8 heranreicht.

Eine weitere doppelseitig klebend beschichtete Folie, diesmal in Gestalt einer Kreisscheibe 29, klebt auch an der Oberseite der Gummiplatte 28, um die Gummiplatte 28 mit einer zweiteiligen Betätigungsplatte 31 zu verbinden. Die Betätigungsplatte 31 besteht aus einem aus transparentem Kunststoff hergestellten unteren Abschnitt 32, sowie einem darüber befindlichen Abschnitt 33 in Gestalt einer Metallplatte.

Die Scheibe 29 hat einen Durchmesser, der kleiner ist als der Außendurchmesser der Keramikscheibe 21 und ihre Stärke beträgt ca. 0,17 mm, so daß außerhalb der Scheibe 29 zwischen der Oberseite der Gummiplatte 28 und der Unterseite der Betätigungsplatte 31 ein kleiner Spalt 34 entsteht. Weil die Scheibe 29 koaxial zu dem Abschnitt der Kammer 8 und damit koaxial zu der Scheibe 21 angeordnet ist, liegt der Spalt 34 entsprechend symmetrisch bzw. zentriert bezüglich der Unterseite der Betätigungsplatte 31.

Bei der Betätigungsplatte 31 steht die Metallplatte 33 seitlich über den Abschnitt 32 über, dessen Grundfläche wiederum dem Querschnitt der Öffnung 6 entspricht, damit die Betätigungsplatte 31 in der Öffnung 6 ein hinreichendes Seitenspiel hat.

Die Stärke des sandwichartigen Stapels, bestehend aus der Zwischenplatte 17 ,der Gummiplatte 28 , den Klebefolien 18 und 27 sowie der Scheibe 29 einschließlich der Höhe des Abschnittes 32 der Betätigungsplatte 31 ist auf den Abstand der Schulter 13 von der oberen Kante des Randes 7 so abgestimmt, daß die Unterseite der Metallplatte 33 mit der Oberseite des Randes 7 einen Spalt von ca. 0,1 mm bildet, der um die gesamte Öffnung 6 herumläuft.

Der oben erwähnte sandwichartige Stapel aus der Betätigungsplatte 31, der Scheibe 29, der Gummiplatte 28, der Zwischenplatte 17 sowie den Klebefolien 18 und 27 ist stoffschlüssig untereinander und mit Hilfe der Klebefolie 18 stoffschlüssig mit der Schulter 13 verbunden, so daß hierdurch an sich schon eine weitgehende Sicherung gegen Herausheben der Betätigungsplatte 31 entsteht. Eine weitere Sicherung geschieht mit Hilfe von insgesamt 4 in den Abschnitt 32 der Betätigungsplatte 31 von der Seite her hereinführenden Sackbohrungen 35, deren Achsen ein Kreuz bilden, dessen Schnittpunkt auf dem Schnittpunkt der Diagonalen in der rechteckigen Öffnung 6 liegen. Diese Sackbohrungen 35 fluchten mit entsprechenden Durchgangsbohrungen 36, die unterhalb des Randes 7 im Bereich der Frontseite 4 ausgebildet sind. In den paarweise miteinander fluchtenden Bohrungen 35 und 36 sitzen nicht veranschaulichte zylindrische Sicherungsstifte, die bspw. stramm in der Sackbohrung 35 eingepaßt sind und in der Bohrung 36 Spiel haben, damit die notwendige Bewegung der Betätigungsplatte 31 durch die Sicherungsstifte nicht behindert wird. Dagegen verhindern die Sicherungsstifte ein Herauslösen der Betätigungsplatte 31 mit Hilfe einfacher Werkzeuge und gleichzeitige gewaltsame Trennung der Klebestellen in dem sandwichartigen Stapel.

Bei der Betätigung des insoweit beschriebenen piezoelektrischen Tasters 2 wird ein geringfügiger Druck auf die Metallplatte 33 der Betätigungsplatte 31 ausgeübt. Dadurch bewegt sich die Betätigungsplatte 31 geringfügig in Richtung auf den Boden 15 der Kammer 8. Hierdurch wird mit Hilfe der Scheibe 29 die Gummiplatte 28 mittig belastet, die ihrerseits die Kraft weitgehend auf die Zwischenplatte 17 verteilt, die randseitig auf der Schulter 13 aufliegt. Dadurch kommt eine wenige Mikrometer starke kalottenförmige Verformung der Zwischenscheibe 17 zustande, die sich auf das damit stoffschlüssig verbundene piezokeramische Element 19 überträgt. Die Durchbiegung des piezokeramischen Elementes 19 läßt an den beiden Stirnflächen der Keramikscheibe 21 eine entsprechende Spannung entstehen, die über die beiden Verbindungsleitungen 23 und 25 der elektronischen Schaltung zugeführt wird.

Der beschriebene piezokeramische Taster 2 arbeitet auch ohne die Scheibe 29, d.h. wenn die Betätigungsplatte 31 vollflächig mit der Gummiplatte 28 verklebt ist oder nur lose aufliegt. Auch dann erfolgt die erwähnte kalottenförmige Durchbiegung der zwischenplatte 17, und zwar deswegen, weil die Zwischenplatte 17 randseitig festgehalten ist und in der Mitte dem Druck nachgeben kann. Allerdings ist in diesem Falle die Betätigungskraft, d.h. die Kraft, die notwendig ist, um eine hinreichende Durchbiegung des piezokeramischen Elementes 19 zu erzeugen, etwas größer als mit der Verwendung der kreisförmigen Scheibe 29.

In jedem Falle ist der piezoelektrische Taster 2 weitgehend gegen Vandalismus geschützt, denn ein übermäßiges Eindrücken der Betätigungsplatte 31 in die Kammer 8 ist nicht möglich. Sobald mit Gewalt auf die Betätigungsplatte 31 gedrückt wird, legt sie sich mit ihrer Unterseite auf der Oberseite des leistenförmigen um die Öffnung 6 herumlaufenden Randes 7 auf und verhindert ein weiteres Eindrücken der Betätigungsplatte 31 in Richtung auf die Kammer 8.

Bei entsprechender Wahl der Stärke der Metallplatte 33 ist eine Verformung weitgehend ausgeschlossen, und das piezokeramische Element 19 bleibt geschützt. Der maximale auftretende Hub, bis sich die Metallplatte 33 auf dem Rand 7 auflegt, ist nicht so groß als das eine Beschädigung der darunterliegenden Bauteile, insbesondere des piezokeramischen Elementes 19 auftreten könnte. Die Schutzwirkung ist besonders gut, wenn die Gummiplatte 28 in der Kammer ein seitliches Spiel hat, falls sie aus einem im wesentlichen inkommpressiblen Material besteht.

Außerdem hat der beschriebene Aufbau des piezoelektrischen Tasters 1 den wesentlichen Vorteil, daß bei einer feuchten Reinigung des Bedientableaus 1 die Reinigungsflüssigkeit, die zwangsläufig durch den seitlichen Spalt zwischen der Seitenwand 12 und der Betätigungsplatte 31 eindringt, nicht bis zum piezokeramischen Element 19 vordringen kann. Bei entsprechendem Zuschnitt der Gummiplatte 28 und/oder infolge der randseitigen ununterbrochenen Verklebung der zwischenplatte 17 mit der Schulter 13 entsteht eine Dichtung, die ein weiteres Vordringen der Reinigungsflüssigkeit in Richtung auf das piezokeramische Element 19 verhindert. Dieses würde sonst bereits bei geringen Feuchtigkeitsmengen den zur Funktion notwendigen Isolationswiderstand zwischen den beiden Stirnseiten der Keramikplatte 21 einbüßen.

Andererseits ist der gewählte Aufbau weitgehend unempfindlich gegenüber Toleranzen bei den Stärken der einzelnen aufeinanderliegenden Bauelemente.

## Patentansprüche

1. Piezoelektrischer Taster (2)
mit einem Gehäuse (3), das an seiner Frontseite (4) eine zu einer Kammer (8) in dem Gehäuse (3) führende Offnung (6) aufweist,
mit einer in die Kammer (8) vorspringenden Auflageeinrichtung (13),
mit einer randseitig auf der Auflageeinrichtung (13) liegenden Zwischenplatte (17), die in ihrer von der Öffnung (6) wegweisenden Unterseite mit einem piezoelektrischen Element (19) verbunden ist,
mit einer auf der Oberseite der Zwischenplatte (17) aufliegenden Platte (28) aus einem elastischen Material,
mit einer Betätigungsplatte (31) sowie
mit Anschlagmitteln (7,33), die den Hub einer in die Kammer (8) gerichteten Bewegung der Betätigungsplatte (31) begrenzen, ehe es zu einer Beschädigung des piezoelektrischen Elements (19) kommt und
mit einer Dichteinrichtung (18,28), die das Keramikelement (19) bezüglich der Öffnung (6) abdichtet.

2. Taster nach Anspruch 1, dadurch gekennzeichnet, daß die Kammer (8) einen der Öffnung (6) gegenüberliegenden Boden (15) mit Durchgängen (24,26) für elektrische Zuleitungen (23,25) zu dem piezoelektrischen Element (19) enthält.

3. Taster nach Anspruch 1, dadurch gekennzeichnet, daß das piezoelektrische Element (19) ein scheibenförmiges, piezokeramisches Element ist und daß die Keramikscheibe (21) mit einer Flachseite mit einer elektrisch leitenden Scheibe (22) verbunden ist, die einen über die Keramikscheibe (21) überstehenden Rand aufweist.

4. Taster nach Anspruch 1, dadurch gekennzeichnet, daß die Auflageeinrichtung (13) von einer durchgehenden ebenen Schulter (13) gebildet ist, deren Schulterfläche in einer Ebene liegt.

5. Taster nach Anspruch 4, dadurch gekennzeichnet, daß die Ebene, in der die Schulterfläche liegt, parallel und im Abstand zu der Offnung (6) in der Frontseite (4) verläuft.

6. Taster nach Anspruch 4, dadurch gekennzeichnet, daß die Kammer (8) in dem Bereich (9) zwischen der Öffnung (6) und der Schulter (13) ein großeres Lichtraumprofil als in einem von der Öffnung (6) aus gesehenen Bereich (11) aufweist, der hinter der Schulter (13) liegt.

7. Taster nach Anspruch 6, dadurch gekennzeichnet, daß der Querschnitt im Bereich zwischen der Schulter (13) und der Öffnung (6) in jedem Abstand von der Schulter (13) gleich ist.

8. Taster nach Anspruch 1, dadurch gekennzeichnet, daß die Zwischenplatte (17) randseitig mit der Auflageeinrichtung (13) verklebt ist.

9. Taster nach Anspruch 8, dadurch gekennzeichnet, daß die Verklebung flüssigkeits-, insbesondere wasserdicht ist.

10. Taster nach Anspruch 1, dadurch gekennzeichnet, daß das piezoelektrische Element (19) auf die Zwischenplatte (17) aufgeklebt ist.

11. Taster nach Anspruch 1, dadurch gekennzeichnet, daß die Zwischenplatte (17) auf ihrer Unterseite mit einer durchgehenden Klebebeschichtung (18) versehen ist, mit der sie einerseits auf der Auflageeinrichtung (13) festgeklebt ist und mit der sie andererseits mit dem piezoelektrischen Element (19) verbunden ist.

12. Taster nach Anspruch 1, dadurch gekennzeichnet, daß die Zwischenplatte (17) eine Metallplatte ist.

13. Taster nach Anspruch 12, dadurch gekennzeichnet, daß die Metallplatte (17) eine Stärke zwischen 0,2 und 0,8 mm, vorzugsweise um 0,4 mm, aufweist.

14. Taster nach Anspruch 1, dadurch gekennzeichnet, daß die elastische Platte (28) aus Gummi oder einem Gummiersatzstoff besteht.

15. Taster nach Anspruch 14, dadurch gekennzeichnet, daß die elastische Platte (28) eine Stärke zwischen 0,5 und 2 mm, vorzugsweise um 1 mm, aufweist.

16. Taster nach Anspruch 1, dadurch gekennzeichnet, daß die elastische Platte (28) mit der Zwischenplatte (17) vollflächig verklebt ist.

17. Taster nach Anspruch 1, dadurch gekennzeichnet, daß die Zwischenplatte (17) und die elastische Platte (28) im wesentlichen gleiche Umrißgestalt aufweisen.

18. Taster nach Anspruch 1, dadurch gekennzeichnet, daß die Umrißgestalt zumindest der Zwischenplatte (17) der Umrißgestalt der Öffnung (6) entspricht.

19. Taster nach Anspruch 1, dadurch gekennzeichnet, daß die der Öffnung (6) zugekehrte Oberseite der elastischen Platte (28) gegenüber der Öffnung (6) zurückversetzt angeordnet ist.

20. Taster nach Anspruch 1, dadurch gekennzeichnet, daß die Betätigungsplatte (31) zumindest einen Abschnitt (32) aufweist, dessen Außenkontur an den Querschnitt der Öffnung (6) angepaßt ist, und daß die Betätigungsplatte (31) mit diesem Abschnitt (32) durch die Öffnung (6) in die Kammer (8) reicht.

21. Taster nach Anspruch 1, dadurch gekennzeichnet, daß zwischen der Betätigungsplatte (31) und der elastischen Platte (28) eine Scheibe (29) liegt, deren Fläche kleiner ist als die Fläche der Zwischenplatte (17) und deren Stärke zwischen 0,1 bis 0,8 mm, vorzugsweise um 0,17 mm, liegt.

22. Taster nach Anspruch 21, dadurch gekennzeichnet, daß die zwischen der Betätigungsplatte (31) und der elastischen Platte (28) befindliche Scheibe (29) eine beidseitig klebend beschichtete Kunststofffolie ist.

23. Taster nach Anspruch 21, dadurch gekennzeichnet, daß die Scheibe (29) eine Kreisscheibe ist, deren Durchmesser kleiner als die kleinste Abmessung der Außenkonturen der Zwischenplatte (17) ist.

24. Taster nach Anspruch 20, dadurch gekennzeichnet, daß die Betätigungsplatte (31) einen zweiten Abschnitt (33) aufweist, der an einer planen Schulter in den ersten Abschnitt (32) übergeht, daß die Schulter über den ersten Abschnitt (32) übersteht und zusammen mit dem Rand (7) der Öffnung (6) die den Hub begrenzenden Anschlagmittel bilden.

25. Taster nach Anspruch 1, dadurch gekennzeichnet, daß der Betätigungsplatte (31) Sicherungsmittel (35,36) zugeordnet sind, die die Betätigungsplatte (31) gegen ein Herausheben sichern.

26. Taster nach Anspruch 25, dadurch gekennzeichnet, daß die Sicherungsmittel von in dem ersten Abschnitt (32) der Betätigungsplatte (31) angebrachten Bohrungen (35) gebildet sind, in denen Sicherungsstifte sitzen, die anderenends in Bohrungen (36) stecken, die im Bereich zwischen der Öffnung (6) und der Auflageeinrichtung (12) von außerhalb des Gehäuses (3) in die Kammer (8) führen.

27. Taster nach Anspruch 26, dadurch gekennzeichnet, daß die Achsen der Bohrungen (35,36) parallel zu der von der Zwischenplatte (17) definierten Ebene verlaufen.

28. Taster nach Anspruch 26, dadurch gekennzeichnet, daß die Sicherungsstifte in den Bohrungen (35) der Betatigungsplatte (31) oder den Bohrungen (36) des Gehauses (3) mit radialem Spiel sitzen.

29. Taster nach Anspruch 26, dadurch gekennzeichnet, daß insgesamt vier Sicherungsstifte vorgesehen sind.

## Claims

1. Piezoelectric key switch (2)
having a casing (3), which on its front side (4) has an opening (6) leading to a chamber (8) in the casing (3),
having a supporting arrangement (13) projecting into the chamber (8),
having an intermediate plate (17), which lies on the supporting arrangement (13) on the edge side and is connected to a piezoelectric element (19) at its underside pointing away from the opening (6),
having a plate (28) made of an elastic material lying on the upper side of the intermediate plate (17),
having a control plate (31), and
having stop means (7, 33) which restrict the stroke of a movement of the control plate (31) directed into the chamber (8) before damage to the piezoelectric element (19) results and
having a sealing arrangement (18, 28) which seals the ceramic element (19) relative to the opening (6).

2. Key switch according to Claim 1, characterised in that the chamber (8) contains a base (15) lying opposite the opening (6) with passages (24, 26) for electrical leads (23, 25) to the piezoelectric element (19).

3. Key switch according to Claim 1, characterised in that the piezoelectric element (19) is a disc-shaped, piezoceramic element; and that the ceramic disc (21) is connected at a flat side to an electrically conductive disc (22) which has an edge protruding above the ceramic disc (21).

4. Key switch according to Claim 1, characterised in that the supporting arrangement (13) is formed by a continuous plane shoulder (13), the shoulder face of which lies in a plane.

5. Key switch according to Claim 4, characterised in that the plane in which the shoulder face lies runs parallel to and at a distance from the opening (6) in the front side (4).

6. Key switch according to Claim 4, characterised in that in the region (9) between the opening (6) and the shoulder (13), the chamber (8) has a larger clearance than in a region (11) behind the shoulder (13) viewed from the opening (6).

7. Key switch according to Claim 6, characterised in that the cross-section in the region between the shoulder (13) and the opening (6) is equal at every distance from the shoulder (13).

8. Key switch according to Claim 1, characterised in that the intermediate plate (17) is adhered to the supporting arrangement (13) on the edge side.

9. Key switch according to Claim 8, characterised in that the adhesive connection is liquid-tight, in particular watertight.

10. Key switch according to Claim 1, characterised in that the piezoelectric element (19) is adhered onto the intermediate plate (17).

11. Key switch according to Claim 1, characterised in that on its underside, the intermediate plate (17) is provided with a continuous adhesive coating (18) with which it is firmly adhered on one side to the supporting arrangement (13) and with which it is joined on the other side to the piezoelectric element (19).

12. Key switch according to Claim 1, characterised in that the intermediate plate (17) is a metal plate.

13. Key switch according to Claim 12, characterised in that the metal plate (17) has a thickness of between 0.2 and 0.8 mm, preferably 0.4 mm.

14. Key switch according to Claim 1, characterised in that the elastic plate (28) is made of rubber or a rubber substitute.

15. Key switch according to Claim 14, characterised in that the elastic plate (28) has a thickness of between 0.5 and 2 mm, preferably 1 mm.

16. Key switch according to Claim 1, characterised in that the elastic plate (28) is adhered to the intermediate plate (17) over its full surface.

17. Key switch according to Claim 1, characterised in that the intermediate plate (17) and the elastic plate (28) have essentially the same contour.

18. Key switch according to Claim 1, characterised in that the contour at least of the intermediate plate (17) corresponds to the contour of the opening (6).

19. Key switch according to Claim 1, characterised in that the upper side of the elastic plate (28) facing the opening (6) is set back in relation to the opening (6).

20. Key switch according to Claim 1, characterised in that the control plate (31) has at least one section (32), the outer contour of which is coordinated to the cross-section of the opening (6), and that with this section (32) of the control plate (31) extends through the opening (6) into the chamber (8).

21. Key switch according to Claim 1, characterised in that a disc (29) is located between the control plate (31) and the elastic plate (28), and the area of said disc is smaller than the area of the intermediate plate (17) and its thickness amounts to between 0.1 and 0.8 mm, preferably 0.17 mm.

22. Key switch according to Claim 21, characterised in that the disc (29) located between the control plate (31) and the elastic plate (28) is a plastic foil with adhesive coating on both sides.

23. Key switch according to Claim 21, characterised in that the disc (29) is a circular disc, the diameter of which is smaller than the smallest dimension of the outer contours of the intermediate plate (17).

24. Key switch according to Claim 20, characterised in that the control plate (31) has a second section (33), which merges into the first section (32) at a plane shoulder; that the shoulder protrudes above the first section (32) and together with the edge (7) of the opening (6) forms the stop means restricting the stroke.

25. Key switch according to Claim 1, characterised in that securing means (35, 36) are provided for the control plate (31) to secure the control plate (31) against removal.

26. Key switch according to Claim 25, characterised in that the securing means are formed by holes (35) provided in the first section (32) of the control plate (31), in which securing pins sit with their other ends inserted in holes (36) which pass from outside the casing (3) into the chamber (8) in the region between the opening (6) and the supporting arrangement (12).

27. Key switch according to Claim 26, characterised in that the axes of the holes (35, 36) run parallel to the plane defined by the intermediate plate (17).

28. Key switch according to Claim 26, characterised in that the securing pins sit in the holes (35) of the control plate (31) or the holes (36) of the casing (3) with radial play.

29. Key switch according to Claim 26, characterised in that four securing pins are provided overall.

## Revendications

1. Bouton-poussoir (2) piézo-électrique
avec un boîtier (3) qui comporte sur sa face frontale (4) une ouverture (6) menant à une chambre (8) à l'intérieur du boîtier (3),
avec un dispositif d'appui (13) qui fait saillie dans la chambre (8),
avec une plaque (17) intermédiaire qui repose au niveau de son bord sur le dispositif d'appui (13) et dont la face inférieure éloignée de l'ouverture (6) est liée à un élément (19) piézo-électrique,
avec une plaque (28) en un matériau élastique appliquée sur la la face supérieure de la plaque (17) intermédiaire,
avec une plaque d'actionnement (31),
avec des moyens formant butées (7, 33) qui limitent la course de déplacement de la plaque d'actionnement (31) en direction de l'intérieur de la chambre (8) avant qu'intervienne une détérioration de l'élément (19) piézo-électrique et
avec un dispositif d'étanchéité (18, 28) qui assure l'étanchéité de l'élément céramique (19) vis-à-vis de l'ouverture (6).

2. Bouton-poussoir selon la revendication 1, caractérisé par le fait que la chambre (8) comporte, en vis-à-vis de l'ouverture (6), un fond (15) avec des passages (24, 26) pour des lignes (23, 25) électriques menant à l'élément (19) piézo-électrique.

3. Bouton-poussoir selon la revendication 1, caractérisé par le fait que l'élément (19) piézo-électrique est un élément piézo-céramique en forme de disque et par le fait que le disque de céramique (21) est lié par une face plane à un disque (22) électro-conducteur dont le bord dépasse par rapport au disque de céramique (21).

4. Bouton-poussoir selon la revendication 1, caractérisé par le fait que le dispositif d'appui (13) est formé par un épaulement (13) plan continu, dont la surface est située dans un plan.

5. Bouton-poussoir selon la revendication 4, caractérisé par le fait que le plan dans lequel est située la surface de l'épaulement est parallèle à l'ouverture (6) dans la face avant (4) et s'étend à distance de celle-ci.

6. Bouton-poussoir selon la revendication 4, caractérisé par le fait que la chambre (8), dans la région (9) entre l'ouverture (6) et l'épaulement (13), présente une ouverture libre qui est supérieure à celle d'une zone (11) qui, vu depuis l'ouverture (6), est située derrière l'épaulement (13).

7. Bouton-poussoir selon la revendication 6, caractérisé par le fait que la section dans la région entre l'épaulement (13) et l'ouverture (6) est constante quelle que soit la distance par rapport à l'épaulement (13).

8. Bouton-poussoir selon la revendication 1, caractérisé par le fait que la plaque (17) intermédiaire est collée au niveau du bord sur le dispositif d'appui (13).

9. Bouton-poussoir selon la revendication 8, caractérisé par le fait que la liaison par collage est étanche aux liquides, notamment est étanche à l'eau.

10. Bouton-poussoir selon la revendication 1, caractérisé par le fait que l'élément (19) piézo-électrique est collé sur la plaque (17) intermédiaire.

11. Bouton-poussoir selon la revendication 1, caractérisé par le fait que la plaque (17) intermédiaire est pourvue sur sa face inférieure d'un revêtement (18) adhésif continu à l'aide duquel la plaque (17) intermédiaire d'une part est fermement collée au dispositif d'appui (13) et d'autre part est liée à l'élément (19) piézo-électrique.

12. Bouton-poussoir selon la revendication 1, caractérisé par le fait que la plaque (17) intermédiaire est une plaque de métal.

13. Bouton-poussoir selon la revendication 12, caractérisé par le fait que la plaque de métal (17) a une épaisseur comprise entre 0,2 et 0,8 mm, de préférence de 0,4 mm.

14. Bouton-poussoir selon la revendication 1, caractérisé par le fait que la plaque (28) élastique est en caoutchouc ou en un produit de remplacement du caoutchouc.

15. Bouton-poussoir selon la revendication 14, caractérisé par le fait que la plaque (28) élastique a une épaisseur comprise entre 0,5 et 2 mm, de préférence de 1 mm.

16. Bouton-poussoir selon la revendication 1, caractérisé par le fait que la plaque (28) élastique est collée sur toute sa surface à la plaque (17) intermédiaire.

17. Bouton-poussoir selon la revendication 1, caractérisé par le fait que la plaque (17) intermédiaire et la plaque (28) élastique ont sensiblement le même contour.

18. Bouton-poussoir selon la revendication 1, caractérisé par le fait que le contour d'au moins la plaque (17) intermédiaire correspond au contour de l'ouverture (6).

19. Bouton-poussoir selon la revendication 1, caractérisé par le fait que la face supérieure tournée vers l'ouverture (6) de la plaque (28) élastique est en retrait par rapport à l'ouverture (6).

20. Bouton-poussoir selon la revendication 1, caractérisé par le fait que la plaque d'actionnement (31) comporte au moins une partie (32) dont le contour est adapté à la section de l'ouverture (6) et par le fait que la plaque d'actionnement (31) pénètre par cette partie (32) dans la chambre (8), à travers l'ouverture (6).

21. Bouton-poussoir selon la revendication 1, caractérisé par le fait qu'entre la plaque d'actionnement (31) et la plaque (28) élastique est disposée une plaque (29) dont la surface est inférieure à la surface de la plaque (17) intermédiaire et dont l'épaisseur est comprise entre 0,1 et 0,8 mm, de préférence est de l'ordre de 0,17 mm.

22. Bouton-poussoir selon la revendication 21, caractérisé par le fait que la plaque (29) disposée entre la plaque d'actionnement (31) et la plaque (28) élastique est un film de matière plastique pourvu d'un revêtement adhésif sur ses deux faces.

23. Bouton-poussoir selon la revendication 21, caractérisé par le fait que la plaque (29) est une plaque circulaire dont le diamètre est inférieur à la plus petite dimension du contour extérieur de la plaque (17) intermédiaire.

24. Bouton-poussoir selon la revendication 20, caractérisé par le fait que la plaque d'actionnement (31) présente une deuxième partie (33) qui se raccorde à un épaulement plan dans la première partie (32), par le fait que l'épaulement dépasse par rapport à la première partie (32) et forme avec le bord (7) de l'ouverture (6) le moyen formant butée limitant la course.

25. Bouton-poussoir selon la revendication 1, caractérisé par le fait que des moyens de fixation (35, 36) sont associés à la plaque d'actionnement (31), lesquels moyens de fixation empêchent le soulèvement de la plaque d'actionnement (31).

26. Bouton-poussoir selon la revendication 25, caractérisé par le fait que les moyens de fixation sont formés par des trous (35) aménagés dans la première partie (32) de la plaque d'actionnement (31), dans lesquels pénètrent des goupilles dont l'autre extrémité est logée dans des trous (36), dans la région entre l'ouverture (6) et le dispositif d'appui (12), qui mènent de l'extérieur du boîtier (3) dans la chambre (8).

27. Bouton-poussoir selon la revendication 26, caractérisé par le fait que les axes des trous (35, 36) sont parallèles au plan défini par la plaque (17) intermédiaire.

28. Bouton-poussoir selon la revendication 26, caractérisé par le fait que les goupilles de fixation sont montées avec jeu radial dans les trous (35) de la plaque d'actionnement (31) ou dans les trous (36) du boîtier (3).

29. Bouton-poussoir selon la revendication 26, caractérisé par le fait qu'il est prévu au total quatre goupilles de fixation.
